## Europäisches Patentamt

## European Patent Office

## Office européen des brevets

(19)

(11) Veröffentlichungsnummer : **0 096 190**
**B1**

(12) **EUROPÄISCHE PATENTSCHRIFT**

(45) Veröffentlichungstag der Patentschrift :
19.08.87

(51) Int. Cl.⁴ : **H 01 L 27/22**

(21) Anmeldenummer : **83103617.3**

(22) Anmeldetag : **14.04.83**

(54) **Magnetfeldsensor.**

(30) Priorität : **16.06.82 CH 3717/82**

(43) Veröffentlichungstag der Anmeldung :
**21.12.83 Patentblatt 83/51**

(45) Bekanntmachung des Hinweises auf die Patenterteilung : **19.08.87 Patentblatt 87/34**

(84) Benannte Vertragsstaaten :
**DE FR GB IT NL SE**

(56) Entgegenhaltungen :
**EP-A- 0 035 103**
**US-A- 3 610 968**
**US-A- 3 714 523**
**US-A- 3 714 559**

(73) Patentinhaber : **LGZ LANDIS & GYR ZUG AG**

**CH-6301 Zug (CH)**

(72) Erfinder : **Popovic, Radivoje, Dr. Ing.**
**Zugerstrasse 24**
**CH-6312 Steinhausen (CH)**
Erfinder : **Baltes, Heinrich Peter, Prof. Dr. Phys.**
**University of Alberta**
**Edmonton Alberta T6G 2E1 (CA)**
Erfinder : **Zajc, Tomislav, Dipl.-Ing.**
**Hasenbühlweg 7**
**CH-6300 Zug (CH)**

(74) Vertreter : **Müller, Hans-Jürgen, Dipl.-Ing. et al**
**Müller, Schupfner & Gauger Lucile-Grahn-Strasse 38**
**Postfach 80 13 69**
**D-8000 München 80 (DE)**

0 096 190

**Beschreibung** .

Anwendungsgebiet und Zweck

Die Erfindung bezieht sich auf einen Magnetfeldsensor, der Transistoren enthält, bei denen mindestens eine erste Transistorzone in zwei getrennte Teilzonen gleicher Transistorfunktion aufgeteilt ist.

Stand der Technik

Bekannt sind Magnetfeldsensoren, gemäss der US-PS 3 714 559 bestehend aus einem « split drain » MOS-Transistor, gemäss der US-PS 3 714 523 bestehend aus einem « split drain/split gate » MOS-Transistor und gemäss « IBM J. Res. Develop. Vol. 25, No. 3, May 1981, A magnetic sensor utilizing an avalanching semiconductor device, A.W. Vinal », bestehend aus einem « split collector » Bipolar-Transistor.

Die in den beiden angegebenen US-Patentschriften beschriebenen Magnetfeldsensoren besitzen eine Empfindlichkeit, die für gewisse Anwendungen zu niedrig ist. In diesem Fall benötigen sie zusätzlich noch einen nachgeschalteten Verstärker, mit dem Nachteil, dass die Wirkung von dessen Offset-Spannung und von dessen Rauschen sich zu der Wirkung derjenigen des Magnetfeldsensors addieren. Der von Vinal beschriebene Magnetfeldsensor besitzt zwar eine hohe Empfindlichkeit, er ist jedoch unstabil wegen seiner Arbeitsweise im Lawineneffekt-Gebiet und die dadurch bedingte Injektion heisser Ladungsträger ins Oxyd.

Aus der US-PS 3 610 968 sind gemäss der Fig. 5 und der Fig. 10 der Aufbau von Magnetowiderständen bekannt, die z. B. zwei zu zwei gemäss der Fig. 15 extern derart miteinander verbunden sind, dass ein Schaltbild entsteht, das unter anderem komplementäre Transistoren enthält, die aus zwei getrennten Teilschichten gleichen Leistungstyps bestehen, wobei eine Teilschicht des ersten Transistors mit einer Teilschicht des zweiten Transistors verbunden ist. Bei den beiden Teilschichten eines Transistors handelt es sich jedoch um Teilschichten unterschiedlicher Funktion, nämlich um die Kollektor- und die Ermitterschicht des Transistors.

Aufgabe und Lösung

Es ist ein stabiler Magnetfeldsensor zu realisieren, dessen Empfindlichkeit ohne Verwendung eines Zusatzverstärkers in der Grössenordnung von 10 Volt/Tesla liegt und der mittels einer Standard-MOS- oder Standard Bipolar-Technologie herstellbar ist.

Die genannte Aufgabe wird erfindungsgemäss durch die im Kennzeichen des Anspruchs 1 angegebenen Merkmale gelöst.

Ausführungsbeispiele der Erfindung sind in der Zeichnung dargestellt und werden im folgenden näher beschrieben.

Es zeigen :

Figur 1   Einen Magnetfeldsensor mit geteilten « Drain »-Zonen,

Figur 2   einen Magnetfeldsensor mit geteilten Kollektor-Zonen,

Figur 3   einen Magnetfeldsensor mit geteilten « Drain »- und mit geteilten « Gate »-Zonen,

Figur 4   eine mittels eines CMOS-Inverters aufgebaute Arbeitspunkt-Einstellschaltung,

Figur 5   einen erweiterten Magnetfeldsensor mit Arbeitspunkt-Einstellung und Nullspannungs-Korrektur,

Figur 6   einen Spannungsregler zum Regeln der Nullspannung des Magnetfeldsensors,

Figur 7   einen erweiterten Magnetfeldsensor mit Arbeitspunkt-Einstellung, Nullspannungs-Korrektur und Ausgangssignal-Umtastung,

Figur 8   eine Umtastschaltung,

Figur 9   einen erweiterten Magnetfeldsensor mit einem Rückkopplungs-Netzwerk,

Figur 10   einen Magnetfeldsensor mit « Gate »-Material endlicher, jedoch sehr hoher Resistivität und

Figur 11   einen Magnetkern mit Stromleiter und Magnetfeldsensor.

Gleiche Bezugszahlen bezeichnen in allen Figuren der Zeichnung gleiche Teile.

Beschreibung

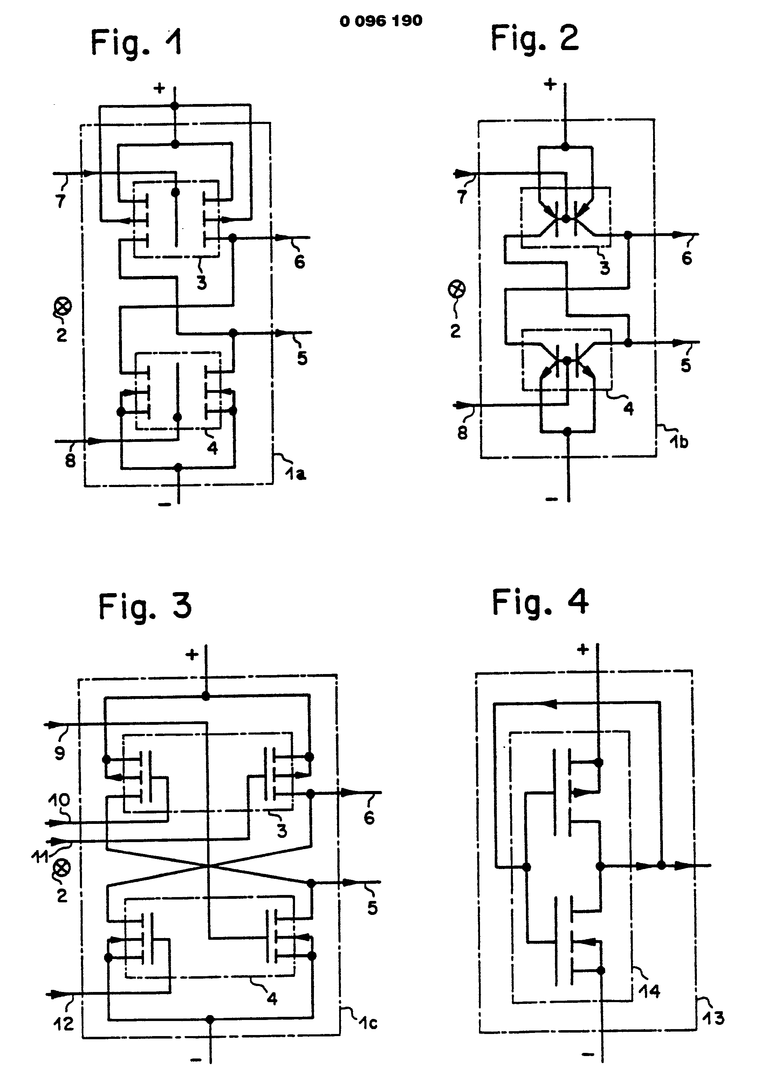

In den Darstellungen der Fig. 1, der Fig. 2, der Fig. 3 und der Fig. 9 gilt immer die linke als erste und die rechte als zweite Teilzone. Werden die Transistortypen vertauscht, so sind immer gleichzeitig auch die Polaritäten der Speisequellen umzukehren.

In der Fig. 1 ist ein Magnetfeldsensor 1a mit geteilten « Drain »-Zonen schematisch dargestellt. Er ist dem Einfluss eines zu messenden, senkrecht zu seiner Kristalloberfläche wirkenden Magnetfeldes 2 unterworfen und besteht aus einem ersten Teilzonen-Transistor 3, z. B. vom P-Typ, und einem zweiten

2

Teilzonen-Transistor 4, z. B. vom N-Typ. Beide Transistoren sind also komplementären Leitungtyps. Jeder der beiden Transistoren 3 und 4 besitzt nur eine einzige, in zwei getrennte Teilzonen gleicher Transistorfunktion aufgeteilte erste Transistorzone, im Beispiel die « Drain »-Zone. Wenigstens die « Source »- und die « Bulk »-Zonen sind dann ungeteilt. Sie werden jedoch schematisch geteilt dargestellt ; dies jedoch nur, um die üblichen Transistordarstellungen verwenden zu können. Das nur zeichnerische Vorhandensein dieser « Teilzonen » ist durch eine elektrische Kurzschlussverbindung zwischen den beiden gezeichneten « Teilzonen » schematisch angedeutet.

Die « Source »- und die « Bulk »-Zone des ersten Transistors 3 sind mit dem positiven Pol und diejenigen des zweiten Transistors 4 mit dem negativen Pol einer Gleichspannungs-Speisequelle verbunden. Die « Source »-Zone als zweite Transistorzone des Transistors 3 bildet somit den Speisespannungs-Eingang (+) und diejenige des Transistors 4 den Speisespannungs-Ausgang (—) des Magnetfeldsensors 1a. Die erste Teilzone der « Drain »-Zone des ersten Transistors 3 liegt an der funktionsgleichen zweiten Teilzone der « Drain »-Zone des zweiten Transistors 4 und bildet den ersten Pol 5 eines zweipoligen Magnetfeldsensor-Ausganges. Die zweite Teilzone der « Drain »-Zone des ersten Transistors 3 ist ihrerseits mit der funktionsgleichen ersten Teilzone der « Drain »-Zone des zweiten Transistors 4 verbunden, d. h. kurzgeschlossen, und bildet den zweiten Pol 6 des Magnetfeldsensor-Ausganges. Die ungeteilte « Gate »-Zone des ersten Transistors 3 bildet als dritte Transistorzone einen ersten einpoligen Eingang 7 und diejenige des zweiten Transistors 4 einen zweiten einpoligen Eingang 8 des Magnetfeldsensors 1a.

In der Fig. 2 ist ein Magnetfeldsensor 1b mit geteilten Kollektor-Zonen schematisch dargestellt. Diese Schaltung entspricht der Schaltung nach der Fig. 1, nur dass die MOS-Transistoren mit geteilter « Drain »-Zone durch Bipolar-Transistoren mit geteilter Kollektor-Zone ersetzt sind, dass keine « Bulk »-Anschlüsse vorhanden sind und dass die Emitter die Aufgabe der « Sources » und die Basen diejenige der « Gates » übernehmen.

In der Fig. 3 ist ein Magnetfeldsensor 1c mit geteilten « Drain »- und mit geteilten « Gate »-Zonen schematisch dargestellt. Diese Schaltung entspricht der Schaltung nach der Fig. 1, nur dass sie vier statt zwei einpolige Eingänge besitzt, einen für jede Teilzone der zwei « Gate »-Zonen. Von den « Gate »-Zonen ist die zweite Teilzone des zweiten Transistors 4 mit einem ersten Eingang 9, die erste Teilzone des ersten Transistors 3 mit einem zweiten Eingang 10, die zweite Teilzone des ersten Transistors 3 mit einem dritten Eingang 11 und die erste Teilzone des zweiten Transistors 4 mit einem vierten Eingang 12 des Magnetfeldsensors 1c verbunden.

Jeder der beiden Teilzonen-Transistoren 3 und 4 arbeitet als Magnetfeldsensor auf an sich bekannte Weise gemäss dem angegebenen Stand der Technik. Durch die beschriebene Verknüpfung der beiden Teilzonen-Transistoren 3 und 4 addieren sich die durch das gemeinsame Magnetfeld 2 in jedem der Teilzonen-Transistoren erzeugten Spannungen, so dass die Empfindlichkeit des Magnetfeldsensors stark erhöht, z. B. verdoppelt wird. Die Schaltungen nach der Fig. 1 und der Fig. 3 können ausserdem mittels einer CMOS-Technologie hergestellt werden. Die Schaltungen nach einer der Fig. 1 bis Fig. 3 sind selbststabilisierend in bezug auf Temperatur- und Speisespannungsänderungen, und jeder ihrer Teilzonen-Transistoren besitzt eine grosse dynamische Last.

Die Eingänge 7, 8 bzw. 9, 10, 11, 12 des Magnetfeldsensors dienen der Arbeitspunkteinstellung mittels einer Arbeitspunkt-Einstellschaltung z. B. gemäss den Angaben in den Fig. 5 und 7 bzw. in der Fig. 9. Die Eingangsspannungen sind so zu wählen, dass einerseits beide Teilzonen-Transistoren sich in der Sättigung befinden und so gute hohe dynamische Lastwiderstände darstellen und andererseits die Ausgangsspannung des Magnetfeldsensors den Mittelwert der Speisespannungen annimmt, also z. B. im Falle von CMOS-Bauelementen den Wert $(V_{DD} + V_{SS})/2$, wobei $V_{DD}$ die « Drain »- und $V_{SS}$ die « Source »-Speisespannung darstellt.

Z. B. bei der Verwendung einer Schaltung gemäss der Fig. 1 besteht die Arbeitspunkt-Einstellschaltung am einfachsten aus einem mittels einer Kurzschlussverbindung rückgekoppelten CMOS-Inverters 14, d. h. einer Arbeitspunkt-Einstellschaltung 13 gemäss der Fig. 4. Der CMOS-Inverter 14 enthält einen P- und einen N-Typ MOS-Transistor, deren beide miteinander verbundenen « Gates » den Eingang des CMOS-Inverters 14 und deren beide miteinander verbundenen « Drains » den Inverterausgang bilden. Die « Source »- und die « Bulk »-Halbleiterschicht des P-Typ Transistors liegt am positiven Pol und diejenigen des N-Typ Transistors am negativen Pol der Gleichspannungs-Speisequelle. Am besten besitzen die Transistoren des CMOS-Inverters 14 die gleichen oder proportionale Abmessungen wie diejenigen der Teilzonen-Transistoren des Magnetfeldsensors. Die Arbeitsweise der Schaltung nach der Fig. 4 ist an sich bekannt aus dem McMos Handbook der Firma Motorola, Phoenix Arizona, für einen beliebigen Rückkopplungswiderstandswert.

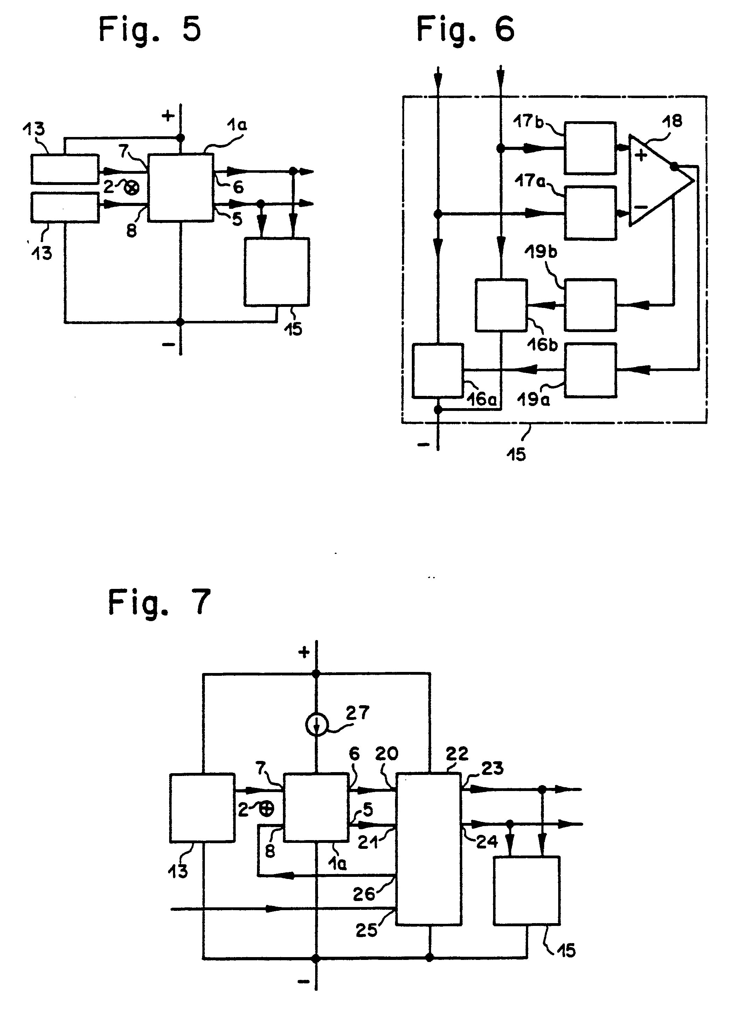

In der Fig. 5 ist ein erweiterter Magnetfeldsensor mit Arbeitspunkt-Einstellung und Nullspannungs-Korrektur als Blockschaltbild dargestellt. Die Ausgänge der beiden Arbeitspunkt-Einstellschaltungen 13 sind mit je einem der beiden Eingänge 7 und 8 des der Wirkung des Magnetfeldes 2 unterworfenen Magnetfeldsensors 1a verbunden. Parallel zum zweipoligen Magnetfeldsensor-Ausgang 5 ; 6 ist ein Spannungsregler 15 geschaltet, welcher die Nullspannung $U_{Offset}$ des Magnetfeldsensors 1a auf Null regelt. Die Arbeitspunkt-Einstellschaltung 13 und der Magnetfeldsensor 1a werden von einer gemeinsamen Gleichspannungs-Speisequelle gespeist, deren Minuspol ebenfalls mit dem Speisungs-Minuspol des Spannungsreglers 15 verbunden ist.

Besitzt der Magnetfeldsensor 1a einen zweipoligen Ausgang, so kann ein Spannungsregler 15 gemäss der Fig. 6 verwendet werden. Jeder Pol des zweipoligen Eingangs des Spannungsreglers 15 ist einerseits direkt mit einem ersten Pol einer spannungsgesteuerten Stromquelle 16a bzw. 16b und andererseits über je einen Integrator 17a bzw. 17b mit dem Minus- bzw. Plus-Eingang eines Differenz-Verstärkers 18 verbunden. Der invertierende un der nichtinvertierende Ausgang des Differenzverstärkers 18 steuern über je ein Stabilisierungsnetzwerk 19a bzw. 19b je einen Steuereingang der spannungsgesteuerten Stromquelle 16a bzw. 16b. Die beiden zweiten Pole der Stromquelle 16a und 16b liegen miteinander am Speisungs-Minuspol des Spannungsreglers 15. Die beiden Integratoren 17a und 17b sind z. B. RC-Glieder. Im einfachsten Fall kann auf den Differenzverstärker 18 und auf die Stabilisierungsnetzwerke 19a und 19b verzichtet werden. Als einfache spannungsgesteuerte Stromquellen 16a und 16b dienen z. B. P-Typ Feldeffekttransistoren.

Ein Spannungsregler 15 gemäss der Fig. 6 kann nur zur Aufhebung der Nullspannung $U_{Offset}$ verwendet werden, wenn das zu messende Magnetfeld 2 ein Wechselstrom-Magnetfeld ist, da nur dann die Gleichung $\int_0^\infty H \cdot dt = 0$ gilt, wobei H das Magnetfeld und t die Zeit darstellen. In diesem Fall ergibt die Integration des Ausgangssignals $(k \cdot H + U_{Offset})$ des Magnetfeldsensors das nur von der Nullspannung $U_{Offset}$ abhängige Resultat :

$$\int_0^\infty (k \cdot Hdt + U_{Offset} \cdot dt) = \int_0^\infty U_{Offset} \cdot dt.$$

Die Integrationszeit der Integratoren 17a und 17b, z. B. das RC der RC-Glieder, muss dabei viel grösser gewählt sein als die Periode des Wechselstrom-Magnetfeldes.

Eine allfällige Gleichspannungs-Komponente im zu messenden Magnetfeld 2 geht in $U_{Offset}$ ein und wird ebenfalls aufgehoben. Dies ist ein Vorteil im Hinblick auf allfällige langsam variierende Stör- und Streufelder. Ein Nachteil ist, dass eine Gleichspannungs-Komponente, deren Messung allenfalls erwünscht ist, ebenfalls unterdrückt wird.

In der Fig. 7 ist ein erweiterter Magnetfeldsensor mit Arbeitspunkt-Einstellung, Nullspannungs-Korrektur und Ausgangssignal-Umtastung schematisch wiedergegeben. Die Arbeitspunkt-Einstellschaltung 13 steuert den ersten Eingang 7 des Magnetfeldsensors 1a, dessen zweipoliger Ausgang 5 ; 6 direkt auf einen zweipoligen Signaleingang 20 ; 21 einer Umtastschaltung 22 geführt ist. Ein zweipoliger Signalausgang 23 ; 24 der letzteren bildet den Ausgang des erweiterten Magnetfeldsensors, dessen Ausgang der Spannungsregler 15 parallelgeschaltet ist. Ein Steuereingang 25 der Umtastschaltung 22 wird von einem rechteckförmigen Hochfrequenz-Taktsignal gesteuert, während ein Rückkopplungsausgang 26 der Umtastschaltung 22 mit dem zweiten Eingang 8 des Magnetfeldsensors 1a verbunden ist. Die Arbeitspunkt-Einstellschaltung 13 und die Umtastschaltung 22 werden direkt und der Magnetfeldsensor 1a über eine Gleichstromquelle 27 von einer gemeinsamen Gleichspannungs-Speisequelle gespeist, wobei die Gleichstromquelle 27 zwischen dem positiven Pol dieser Gleichspannungs-Speisequelle und dem positiven Pol des Speiseeingangs des Magnetfeldsensors 1a liegt. Der Speisungs-Minuspol des Spannungsreglers 15 ist auf den Minuspol der Gleichspannungs-Speisequelle geführt.

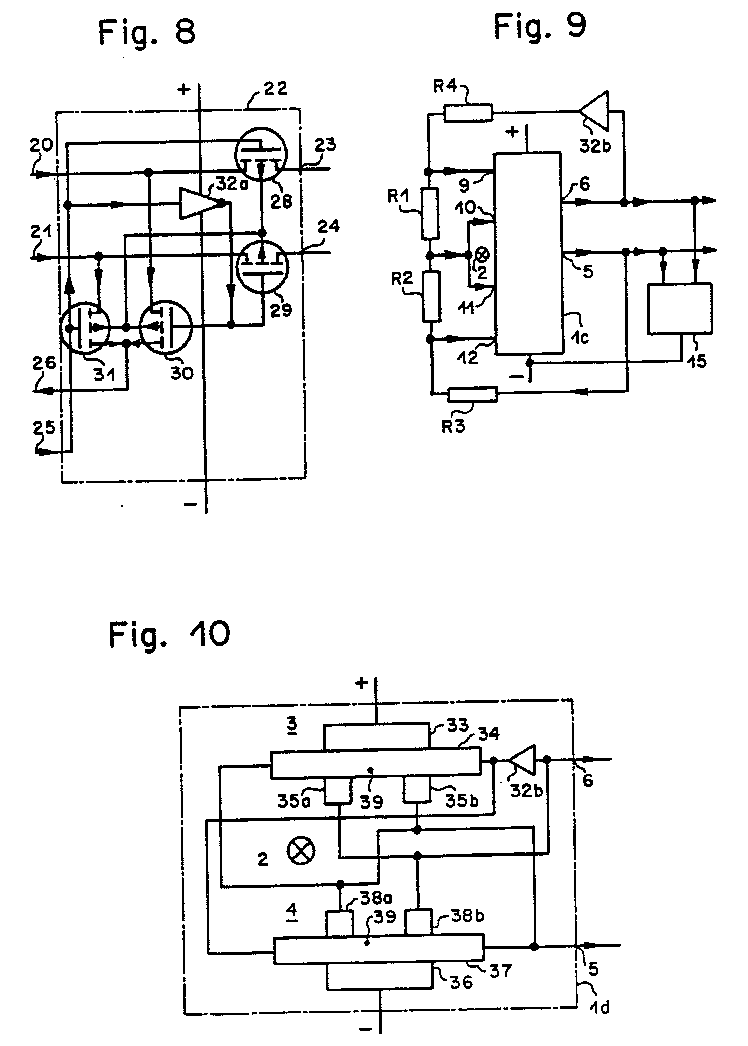

In der Fig. 8 ist die Umtastschaltung 22 dargestellt. Der erste Pol 20 ihres Signaleingangs 20 ; 21 ist über einen ersten Schalter 28 mit dem ersten Pol 23 und der zweite Pol 21 über einen zweiten Schalter 29 mit dem zweiten Pol 24 ihres Signalausganges 23 ; 24 verbunden. Der erste Pol 20 des Signaleinganges 20 ; 21 liegt noch zusätzlich über einen dritten Schalter 30 und sein zweiter Pol 21 über einen vierten Schalter 31 am gemeinsamen Rückkopplungsausgang 26. Der Steuereingang 25 steuert direkt die Steuereingänge des ersten und des vierten Schalters 28 und 31 und über einen an sich bekannten Inverter 32a, z. B. einen MC 14 000 der Firma Motorola, Phoenix, Arizona, die Steuereingänge des zweiten und des dritten Schalters 29 und 30. Die vier Schalter sind z. B. P-Typ Feldeffekt-Transistoren. Ihre « Bulk »-Zonen sind dann mit dem negativen Pol einer Gleichspannungs-Speisequelle verbunden, welche ihrerseits ebenfalls den Inverter 32a speist. Die vier Schalter können auch an sich bekannte « transmission gates » sein, z. B. MC 14016 der Firma Motorola.

Der erste und der dritte Schalter 28 und 30 bilden zusammen einen ersten Umschalter 28 ; 30, welcher abwechselnd den ersten Pol 20 des Signaleinganges 20, 21 der Umtastschaltung 22 mit dem ersten Pol 23 des Signalausganges 23 , 24 und mit dem Rückkopplugsausgang 26 verbindet. Desgleichen bilden der zweite und der vierte Schalter 29 und 31 zusammen einen zweiten Umschalter 29 ; 31 welcher seinerseits den zweiten Pol 21 des Signaleinganges 20 ; 21 mit dem zweiten Pol 24 des Signalausganges 23 ; 24 und mit dem Rückkopplungsausgang 26 verbindet. Beide Umschalter werden im Gegentakt betrieben mit Hilfe des am Steuereingang 25 angelegten Hochfrequenz-Taktsignals. Somit ist jeweils während einer jeden Tastphase ein Pol 6 oder 5 des Magnetfeldsensor-Ausganges gemäss der Fig. 7 mit dem zugehörigen Pol 23 bzw. 24 des Signalausganges 23 ; 24 des erweiterten Magnetfeldsensors verbunden, während der andere Pol 5 bzw. 6 über eine Kurzschlussverbindung direkt auf den zweiten Eingang 8 des Magnetfeldsensors 1a bzw. 1b zurückgekoppelt ist.

Es kann auch in der Umtastschaltung 22 jeder Schalter eines der beiden Schalterpaare 28 ; 31 bzw. 29 ; 30 durch eine Kurzschlussverbindung ersetzt und das andere Schalterpaar weggelassen werden. Oder mit andere Worten : Die geschlossenen Kontakte der beiden Umschalter 28 ; 30 und 29 ; 31 können je durch eine Kurzschlussverbindung ersetzt werden. Man erhält dann einen erweiterten Magnetfeldsensor mit einem einpoligen Ausgang. Soll dies vermieden werden und wird ein zweipoliger Ausgang benötigt, ist die beschriebene Umtastschaltung 22 zu verwenden. Der positive und der negative Pol des Ausgangssignals des Magnetfeldsensors 1a bzw. 1b wird dann abwechselnd hochfrequenzmässig abgetastet (« sampling »). Bedingt durch die 180°-Phasenverschiebung der Signale an den beiden abgetasteten Signalpolen wird die Empfindlichkeit des erweiterten Magnetfeldsensors verdoppelt. Auch ist die weitere Verwertung eines Hochfrequenzsignals viel einfacher.

In der Fig. 9 ist ein erweiterter Magnetfelsensor mit einem Rückkopplungsnetzwerk wiedergegeben. Der zweite und der dritte Eingang 10 und 11 des Magnetfeldsensors 1c sind miteinander mittels einer Kurzschlußverbindung direkt und über einen ersten Widerstand R1 mit dem ersten Eingang 9 und über einen zweiten Widerstand R2 mit dem vierten Eingang 12 des Magnetfeldsensors 1c verbunden. Zusätzlich ist der erste Pol 5 des zweipoligen Magnetfeldsensor-Ausganges 5 ; 6 über einen dritten Widerstand R3 auf den vierten Eingang 12 und der zweite Pol 6 dieses Ausganges über eine Reihenschaltung eines Spannungsfolgers 32b und eines vierten Widerstandes R4 auf den ersten Eingang 9 des Magnetfeldsensors 1c geführt, wobei dem zweipoligen Ausgang 5 ; 6 ein Spannungsregler 15 parallelgeschaltet ist, dessen Speisungs-Minuspol mit dem Minuspol einer den Magnetfeldsensor speisenden Gleichspannungs-Speisequelle verbunden ist. Der Vorteil dieser Schaltung besteht darin, dass die Grösse der Rückkopplung mittels der vier Widerstände frei wählbar ist und so eine hohe Empfindlichkeit eingestellt werden kann.

Bei einer perfekt symmetrischen Schaltung gemäss der Fig. 9 besitzen die Spannungen an den beiden Polen des Ausganges 5 ; 6 bei Nichtvorhandensein eines Magnetfeldes 2 den gleichen Wert. Beim Vorhandensein eines Magnetfeldes 2 entsteht eine Unsymmetrie in der Stromverteilung der beiden, in der Zeichnung linken und rechten Hälften des ersten Teilzonen-Transistors 3 des Magnetfeldsensors 1c (Fig. 3). Führt die rechte Hälfte mehr Strom als die linke Hälfte, dann erhöht sich die Spannung am Pol 6 des Ausgangs 5-6 und die Spannung am Pol 5 dieses Ausganges wird kleiner. Da jedoch der erste Eingang 9 über einen durch die Widerstände R4 und R1 gebildeten Spannungsteiler mit dem zweiten Pol 6 des Ausganges 5-6 verbunden ist, wird die Spannung am ersten Eingang 9 ebenfalls steigen, was seinerseits ein Ansteigen des Stromes in der, in der Zeichnung rechten Hälfte des zweiten Teilzonen-Transistors 4 veranlasst. Dies verkleinert seinerseits wiederum zusätzlich die Spannung am ersten Pol 5 des Ausganges 5-6. Ahnliches gilt natürlich sinngemäss auch für die in der Zeichnung linke Hälfte des zweiten Teilzonen-Transistors 4, dessen Eingang 12 über einen weiteren durch die Widerstände R3 und R2 gebildeten Spannungsteiler mit dem ersten Pol 5 des Ausganges 5-6 verbunden sind. Durch dieses an sich positiven Rückkopplungen wird die Empfindlichkeit des Magnetfeldsensors 1c erhöht.

Die Schaltung nach der Fig. 9 hat den Nachteil, dass die Abstände zwischen den Teilzonen der « Gates » sehr klein sein müssen und demnach eine « charge coupled device »-Technologie zur Herstellung benötigen. Integriert man jedoch die vier externen Rückkopplungs-Widerstände R1 bis R4 der Fig. 9 ins « Gate »-Material, so wird dieser Nachteil vermieden und es entsteht ein Aufbau gemäss der Fig. 10.

In der Fig. 10 ist ein Magnetfeldsensor 1d mit einer weiten « Gate »-Zone, die sich über die geteilten Kanäle, d. h. Zonen, der Transistoren 3 und 4 erstreckt und wobei das « Gate »-Material einen endlichen, jedoch sehr hohen Widerstandswert besitzt, schematisch dargestellt. Der erste Teilzonen-Transistor 3 besteht aus einer « Source » 33, einem « Gate » 34 und einem « Drain » mit einer ersten « Drain »-Teilzone 35a und einer zweiten « Drain »-Teilzone 35b. Der zweite Teilzonen-Transistor 4 komplementären Leistungstyps besteht aus einer « Source » 36, einem « Gate » 37 und einem « Drain » mit einer ersten « Drain »-Teilzone 38a und einer zweiten « Drain »-Teilzone 38b. Jedes « Gate » ist sehr breit und besteht, wie bereits erwähnt, aus Material von endlichem, jedoch sehr hohem Widerstand. Es besitzt an jedem seiner beiden Enden einen Anschluss. Der erste dieser Anschlüsse und die erste « Drain »-Teilzone ist in der Zeichnung links und der zweite Anschluss bzw. die zweite Teilzone rechts dargestellt.

Direkt miteinander verbunden sind :

Der erste « Gate »-Anschluss und die zweite « Drain »-Teilzone 35b des ersten Teilzonen-Transistors 3 mit der ersten « Drain »-Teilzone 38a und dem zweiten « Gate »-Anschluss des zweiten Teilzonen-Transistors 4 sowie mit dem ersten Pol 5 des zweipoligen Magnetfeldsensor-Ausganges 5 ; 6.

Der Eingang des Spannungsfolgers 32b und die erste « Drain »-Teilzone 35a des ersten Teilzonen-Transistors 3 mit der zweiten « Drain »-Teilzone 38b und dem zweiten Pol 6 des zweipoligen Magnetfeldsensor-Ausganges 5-6.

Der Ausgang des Spannungsfolgers 32b mit dem zweiten « Gate »-Anschluss des ersten Teilzonen-Transitors 3 und dem ersten « Gate »-Anschluss des zweiten Teilzonen-Transistors 4.

Unter dem Einfluss einer elektrischen Spannungs an den beiden Enden der « Gates » werden diese von einem elektrischen Strom durchflossen, so dass der zentrale Teil 39 der « Gate »-Widerstände als Rückkopplungswiderstand wirkt. Diese Rückkopplung verstärkt das Ausgangssignal des Magnetfeldsensors 1d und vergrössert damit dessen Empfindlichkeit. Auch hängen die Eigenschaften dieser Schaltung weniger ab von den Eigenschaften der Teilzonen-Transistoren, als dies bei den anderen beschriebenen Schaltungen der Fall ist.

Der Spannungsfolger 32b, bestehend z. B. aus einem Verstärker mit dem Spannungsverstärkungsfaktor « 1 » oder einem « Source Follower », dient in den Darstellungen der Fig. 9 und der Fig. 10 durch seinen hochohmigen Eingang der Entlastung des Ausganges 5-6 des Magnetfeldsensors 1c bzw. 1d, so dass die Rückkopplungswiderstände diesem Ausgang 5-6 nicht mehr direkt parallel geschaltet sind.

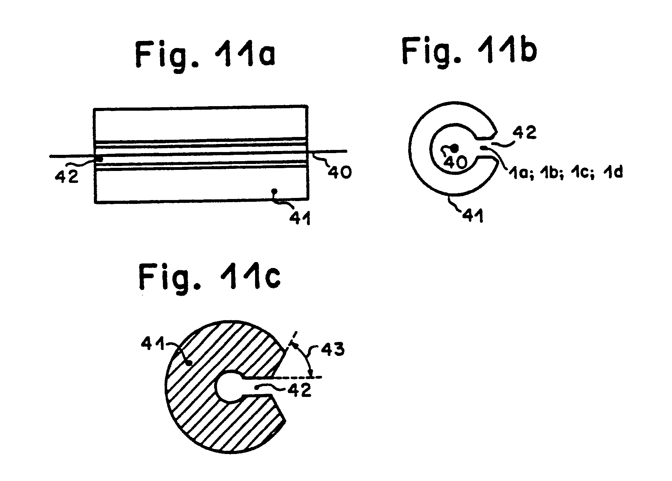

Die beschriebenen Magnetfeldsensoren werden z. B. verwendet zum Messen des elektrischen Stroms in einem Elektrizitätszähler. Eine in den Fig. 11a und 11b dargestellte vorteilhafte Anordnung besteht darin, den Leiter 40 des elektrischen Stroms entlang der Längsachse eines länglichen ringförmigen Magnetkerns 41 aus weichmagnetischem Material, z. B. aus Mumetall, anzuordnen, der zur Bildung eines achsparallelen Luftspaltes 42 der Länge nach aufgeschlitzt ist. Im Luftspalt 42 befindet sich ein Magnetfeldsensor 1a, 1b, 1c bzw. 1d. Die Fig. 11c zeigt den Querschnitt des Luftspaltes 42, dessen Magnetkern-Seitenflächen auf der radialen Ringinnenseite parallel zueinander und parallel zur Oberfläche des Magnetfeldsensors 1a, 1b, 1c bzw. 1d verlaufen. Auf der radialen Ringaussenseite laufen sie dagegen mit einem ein Kreissegment aus dem Magnetkernquerschnitt ausschneidenden, doppelten Winkel 43 auseinander, wobei der Winkel 43 z. B. einen Wert 60° besitzt, was eine magnetische Entlastung des Magnetkernes 41 bewirkt. Dadurch wird erreicht, dass er einerseits bei einem zu messenden Wechselstrom von 200 A nicht gesättigt wird, so dass der Einfluss der Nichtlinearität des Magnetmaterials auf den Messfehler klein bleibt, und dass andererseits der Einfluss eines äusseren Störfeldes in der Grössenordnung von 50 A/cm auf den Magnetfeldsensor möglichst Schirm wirkt. Der Sensor besitzt solche Dimensionen, dass er in erster Annäherung im Verhältnis zu den Abmessungen der Magnetkern-Seitenflächen des Luftspaltes 42 als punktförmig angenommen werden kann und ist in dem Teil des Luftspaltes angeordnet, der parallele Magnetkern-Seitenflächen besitzt.

**Patentansprüche**

1. Magnetfeldsensor (1a, 1b, 1c, 1d), der Transistoren (3, 4) enthält, bei denen mindestens eine erste Transistorzone in zwei getrennte Teilzonen gleicher Transistorfunktion aufgeteilt ist, dadurch gekennzeichnet,

daß zwei solche in funktionsgleiche Teilzonen aufgeteilte Transistoren (3, 4) komplementären Leitungstyps vorhanden sind,

daß eine erste Teilzone der ersten Transistorzone des ersten dieser Transistoren mit der funktionsgleichen zweiten Teilzone des komplementären zweiten Transistors und die zweite Teilzone der ersten Transistorzone des ersten Transistors mit der funktionsgleichen ersten Teilzone des komplementären zweiten Transistors kurzgeschlossen sind,

daß die beiden Teilzonen der ersten Transistorzone eines der beiden Transistoren einen zweipoligen Ausgang (5, 6) bilden und daß die wenigstens eine ungeteilte zweite Transistorzone des einen Transistors (3) den Speisespannungs-Eingang (+) und die wenigstens eine ungeteilte zweite Transistorenzone des anderen Transistors (4) den Speisespannungs-Ausgang (—) des Magnetfeldsensors (1a, 1b, 1c, 1d) bilden.

2. Magnetfeldsensor nach Anspruch 1, dadurch gekennzeichnet, dass jede aus zwei funktionsgleichen Teilzonen bestehende erste Transistorzone die « Drain »-Zone und jede einen Pol des Speisespannungs-Eingangs bzw. -Ausgangs bildende zweite Transistorzone die « Source »-Zone zweier komplementärer MOS-Transistoren sind.

3. Magnetfeldsensor nach Anspruch 1 oder 2, dadurch gekennzeichnet, dass die dritte Transistorzone der beiden in funktionsgleiche Teilzonen aufgeteilten Transistoren (3 ; 4) ungeteilt und mit dem Ausgang von mindestens einem auf seinen Eingang rückgekoppelten CMOS-Inverter (14) verbunden ist, wobei dessen Transistoren die gleichen oder proportionale räumliche Abmessungen besitzen wie diejenigen der in Teilzonen aufgeteilten Transistoren.

4. Magnetfeldsensor nach einem der Ansprüche 1 bis 3, dadurch gekennzeichnet, dass die erste Teilzone eines der beiden komplementären Transistoren (3 ; 4) mit der dritten ungeteilten Transistorzone des gleichen, in Teilzonen aufgeteilten Transistors verbunden ist, dass die zweite Teilzone dieses Transistors einen einpoligen Ausgang des Magnetfeldsensors bildet und dass ein Pol des Speisespannungs-Eingangs bzw. -Ausgangs von einer Gleichstromquelle (27) gespeist ist.

5. Magnetfeldsensor nach einem der Ansprüche 1 bis 3, dadurch gekennzeichnet, dass mit Hilfe zweier im Gegentakt betriebener Umschalter (28, 30 ; 29, 31) abwechselnd einerseits die erste Teilzone eines der beiden komplementären Transistoren mit dem ersten Pol eines Signalausganges (23) des Magnetfeldsensors und die zweite Teilzone dieses Transistors mit dessen dritter ungeteilter Transistorzone und anderseits die erste Teilzone des gleichen Transistors mit dessen dritter Transistorzone und seine zweite Teilzone mit dem zweiten Pol eines Signalausganges (24) verbunden sind und dass ein Pol des Speisespannungs-Eingangs bzw. -Ausgangs von einer Gleichstromquelle (27) gespeist ist.

6. Magnetfeldsensor nach Anspruch 1 oder 2, dadurch gekennzeichnet, dass die dritte Transistorzone der beiden komplementären Transistoren ebenfalls aus zwei Teilzonen besteht.

7. Magnetfeldsensor nach Anspruch 6, dadurch gekennzeichnet, dass die beiden Teilzonen der dritten Transistorzone der ersten Transistors (3) kurzgeschlossen sind und über je einen Widerstand (R1, R2) mit den beiden Teilzonen der dritten Transistorzone des zweiten Transistors (4) verbunden sind und dass die erste Teilzone der dritten Transistorzone des zweiten Transistors (4) über einen dritten Widerstand (R3) auf die erste Teilzone der ersten Transistorzone des ersten Transistors (3) geschaltet ist und dass die zweite Teilzone der dritten Transistorzone des zweiten Transistors (4) über einen vierten Widerstand (R4) auf den Ausgang eines Spannungsfolgers (32b) geschaltet ist, dessen Eingang seinerseits mit der zweiten Teilzone der ersten Transistorzone des ersten Transistors (3) verbunden ist.

8. Magnetfeldsensor nach Anspruch 1 oder 2, dadurch gekennzeichnet, dass jede dritte Transistorzone der bezüglich der ersten Transistorzone in getrennte Teilzonen aufgeteilten Transistoren (3 ; 4) eine ungeteilte « Gate »-Zone eines MOS-Transistors ist, die sich über die geteilten Kanäle dieser MOS-Transistoren erstreckt und aus Material von endlichem, jedoch sehr hohem Widerstand besteht und an jedem ihrer beiden Enden je einen Anschluss besitzt.

9. Magnetfeldsensor nach Anspruch 8, dadurch gekennzeichnet, dass die erste « Drain »-Teilzone (35a) des ersten Transistors (3) einerseits direkt mit der zweiten « Drain »-Teilzone (38b) des zweiten Transistors (4) und dem zweiten Pol (6) des zweipoligen Magnetfeldsensor-Ausganges (5 ; 6) und andererseits über einen Spannungsfolger (32b) mit dem zweiten « Gate »-Anschluss des ersten Transistors (3) und dem ersten « Gate »-Anschluss des zweiten Transistors (4) verbunden ist und dass der erste « Gate »-Anschluss und die zweite « Drain »-Teilzone (35b) des ersten Transistors (3) mit der ersten « Drain »-Teilzone (38a) und dem zweiten « Gate »-Anschluss des zweiten Transistors (4) sowie mit dem ersten Pol (5) des zweipoligen Magnetfeldsensor-Ausganges (5 ; 6) verbunden sind.

10. Magnetfeldsensor nach Anspruch 1, dadurch gekennzeichnet, dass jede aus zwei Teilzonen bestehende erste Transistorzone die Kollektorzone und jede einen Pol des Speisespannungs-Eingangs bzw. -Ausgangs bildende zweite Transistorzone die Emittenzone der beiden komplementären bipolaren Transistoren sind.

11. Magnetfeldsensor nach Anspruch 5, dadurch gekennzeichnet, dass die Umschalter (28, 30 ; 29, 31) mittels Feldeffekt-Transistoren aufgebaut sind.

12. Magnetfeldsensor nach Anspruch 5, dadurch gekennzeichnet, dass die Umschalter (28, 30 ; 29, 31) mittels « transmission gates » aufgebaut sind.

13. Magnetfeldsensor nach Anspruch 5, dadurch gekennzeichnet, dass die geschlossenen Kontakte der beiden Umschalter (28, 30 ; 29, 31) je durch eine Kurzschlussverbindung ersetzt sind.

14. Magnetfeldsensor nach einem der Ansprüche 1 bis 13, dadurch gekennzeichnet, dass parallel zum zweipoligen Magnetfeldsensor-Ausgang (5 ; 6 bzw. 23 ; 24) ein Spannungsregler (15) geschaltet ist, welcher die Nullspannung des Magnetfeldsensors auf Null regelt und welcher aus je einem Integrator (17a ; 17b), einem Stabilisierungsnetzwerk (19a ; 19b) und einer spannungsgesteuerten Stromquelle (16a ; 16b) pro Ausgangsleiter sowie einem einzigen Differenzverstärker (18) besteht.

15. Magnetfeldsensor nach Anspruch 14, dadurch gekennzeichnet, dass die Integratoren (17a ; 17b) RC-Glieder sind.

16. Magnetfeldsensor nach einem der Ansprüche 1 bis 15, dadurch gekennzeichnet, dass er Messteil eines Elektrizitätszählers ist.

17. Magnetfeldsensor nach Anspruch 16, dadurch gekennzeichnet, dass er im achsparallelen Luftspalt eine zylindrisch ringförmigen Magnetkerns (41) mit seiner Oberfläche parallel zu den Magnetkern-Seitenflächen des Luftspaltes (42) angeordnet ist, wobei die beiden Abmessungen dieser Magnetkern-Seitenflächen viel grösser sind als die Abmessungen des Magnetfeldsensors und wobei der zu messende elektrische Strom einen elektrischen Leiter (40) durchfliesst, welcher in der Längsachse des Magnetkerns angeordnet ist.

18. Magnetfeldsensor nach Anspruch 17, dadurch gekennzeichnet, dass die Magnetkern-Seitenflächen des Luftspaltes (42) auf der radialen Ringinnenseite parallel zueinander und parallel zur Oberfläche des Magnetfeldsensors verlaufen und dass sie dagegen auf der radialen Ringaussenseite mit einem ein Kreissegment aus dem Magnetkernquerschnitt ausschneidenden, doppelten Winkel (zweimal 43) auseinander laufen und dabei der Magnetkern (41) einen magnetischen Schirm bildet.

## Claims

1. A magnetic field sensor (1a, 1b, 1c, 1d) which includes transistors (3, 4) in which at least one first transistor zone is divided into two separate sub-zones with the same transistor function, characterised in that
there are two such transistors (3, 4) of complementary conductivity type, divided into sub-zones with the same function,
a first sub-zone of the first transistor zone of the first of said transistors is short-circuited to the second sub-zone, with the same function, of the complementary second transistor and the second sub-zone of the first transistor zone of the first transistor is short-circuited to the first sub-zone, with the same function, of the complementary second transistor,
the two sub-zones of the first transistor zone of one of the two transistors form a two-pole output (5, 6), and
the at least one undivided second transistor zone of the one transistor (3) forms the feed voltage input (+) and the at least one undivided second transistor zone of the other transistor (4) forms the feed voltage output (—) of the magnetic field sensor (1a, 1b, 1c, 1d).

2. A magnetic field sensor according to claim 1, characterised in that each first transistor zone comprising two sub-zones with the same function is the drain zone and each second transistor zone forming a pole of the feed voltage input or output is the source zone, of two complementary MOS-transistors.

3. A magnetic field sensor according to claim 1 or claim 2 characterised in that the third transistor zone of the two transistors (3 ; 4) which are divided into sub-zones with the same function is undivided and is connected to the output of at least one CMOS-inverter (14) which has a feedback to its input, wherein the transistors thereof have the same or proportional spatial dimensions as those of the transistors which are divided into sub-zones.

4. A magnetic field sensor according to one of claims 1 to 3 characterised in that the first sub-zone of one of the two complementary transistors (3 ; 4) is connected to the third undivided transistor zone of the same transistor which is divided into sub-zones, that the second sub-zone of said transistor forms a single-pole output of the magnetic field sensor, and that a pole of the feed voltage input or output is fed by a direct current source (27).

5. A magnetic field sensor according to one of claims 1 to 3 characterised in that two change-over switches (28, 30 ; 29, 31) operated in a push-pull mode alternately connect on the one hand the first sub-zone of one of the two complementary transistors to the first pole of a signal output (23) of the magnetic field sensor and the second sub-zone of said transistor to its third undivided transistor zone, and on the other hand the first sub-zone of the same transistor to the third transistor zone thereof and its second sub-zone to the second pole of a signal output (24), and that a pole of the feed voltage input or output is fed by a direct current source (27).

6. A magnetic field sensor according to claim 1 or claim 2 characterised in that the third transistor zone of the two complementary transistors also comprises two sub-zones.

7. A magnetic field sensor according to claim 6 characterised in that the two sub-zones of the third transistor zone of the first transistor (3) are short-circuited and are connected by way of respective resistors (R1, R2) to the two sub-zones of the third transistor zone of the second transistor (4) and that the first sub-zone of the third transistor zone of the second transistor (4) is connected by way of a third resistor (R3) to the first sub-zone of the first transistor zone of the first transistor (3) and that the second sub-zone of the third transistor zone of the second transistor (4) is connected by way of a fourth resistor (R4) to the output of a voltage follower (32b) whose input is in turn connected to the second sub-zone of the first transistor zone of the first transistor (3).

8. A magnetic field sensor according to claim 1 or claim 2 characterised in that each third transistor zone of the transistors (3 ; 4) which are divided into separate sub-zones in regard to the first transistor zone is an undivided gate zone of an MOS-transistor which extends over the divided channels of said MOS-transistors and which comprises material of finite but very high resistance and which has a respective terminal at each of its two ends.

9. A magnetic field sensor according to claim 8 characterised in that the first drain sub-zone (35a) of the first transistor (3) is connected on the one hand directly to the second drain sub-zone (38b) of the second transistor (4) and the second pole (6) of the two-pole magnetic field sensor output (5 ; 6), and on the other hand by way of a voltage follower (32b) to the second gate terminal of the first transistor (3) and the first gate terminal of the second transistor (4), and that the first gate terminal and the second drain sub-zone (35b) of the first transistor (3) are connected to the first drain sub-zone (38a) and the second gate terminal of the second transistor (4) and to the first pole (5) of the two-pole magnetic field sensor output (5 ; 6).

10. A magnetic field sensor according to claim 1 characterised in that each first transistor zone which comprises two sub-zones is the collector zone and each second transistor zone which forms a pole of the feed voltage input or output is the emitter zone, of the two complementary bipolar transistors.

11. A magnetic field sensor according to claim 5 characterised in that the change-over switches (28, 30 ; 29, 31) are formed by means of field effect transistors.

12. A magnetic field sensor according to claim 5 characterised in that the change-over switches (28, 30 ; 29, 31) are formed by means of transmission gates.

13. A magnetic field sensor according to claim 5 characterised in that the closed contacts of the two change-over switches (28, 30 ; 29, 31) are respectively replaced by a short-circuit connection.

14. A magnetic field sensor according to one of claims 1 to 13 characterised in that connected in parallel with the two-pole magnetic field sensor output (5 ; 6 or 23 ; 24) is a voltage regulator (15) which regulates the zero voltage of the magnetic field sensor to zero and which respectively comprises an integrator (17a ; 17b), a stabilisation network (19a ; 19b) and a voltage-controlled current source (16a ; 16b) for each output line, and a single differential amplifier (18).

15. A magnetic field sensor according to claim 14 characterised in that the integrators (17a ; 17b) are RC-members.

16. A magnetic field sensor according to one of claims 1 to 15 characterised in that it is the measuring portion of an electricity meter.

17. A magnetic field sensor according to claim 16 characterised in that it is arranged in the air gap, which is parallel to the axis, of a cylindrical-annular magnetic core (41), with its surface parallel to the side faces of the air gap (42) in the magnetic core, wherein the two dimensions of said magnetic core side faces are much greater than the dimensions of the magnetic field sensor and wherein the electrical current to be measured flows through an electrical line (40) which is arranged on the longitudinal axis of the magnetic core.

18. A magnetic field sensor according to claim 17 characterised in that the magnetic core side faces of the air gap (42) extend parallel to each other and parallel to the surface of the magnetic field sensor, on the radially inward side of the ring, and that in contrast on the radially outward side of the ring they diverge at a doubled angle (twice 43) which cuts a segment of a circle out of the magnetic core cross-section, and with that arrangement the magnetic core (41) forms a magnetic screen.

**Revendications**

1. Capteur de champ magnétique (1a, 1b, 1c, 1d), qui contient des transistors (3, 4), dans lesquels au moins une première zone des transistors est subdivisée en deux zones partielles possédant la même fonction dans les transistors, caractérisé en ce

qu'il est prévu de tels transistors (3, 4) possédant les types de conduction complémentaires et qui sont subdivisés en zones partielles ayant des fonctions identiques,

qu'une première zone partielle de la première zone du premier de ces transistors est reliée par court-circuit à la seconde zone partielle de même fonction du second transistor complémentaire et que la seconde zone partielle de la première zone du premier transistor est reliée par court-circuit à la première zone partielle de même fonction du second transistor complémentaire,

que les deux zones partielles de la première zone de l'un des deux transistors forment une sortie bipolaire (5, 6), et

qu'au moins une seconde zone non subdivisée du premier transistor (3) forme l'entrée (+) de la tension d'alimentation et qu'au moins une seconde zone non subdivisée du second transistor (4) forme la sortie (—) de la tension d'alimentation du capteur de champ magnétique (1a, 1b, 1c, 1d).

2. Capteur de champ magnétique selon la revendication 1, caractérisé en ce que chaque première zone des transistors, qui est constituée par deux zones partielles de même fonction, constitue la zone de « drain » et que chaque seconde zone des transistors constituant un pôle de l'entrée ou la sortie de la tension d'alimentation forme la zone de « source » de deux transistors MOS complémentaires.

3. Capteur de champ magnétique selon la revendication 1 ou 2, caractérisé en ce que la troisième zone des deux transistors (3, 4) subdivisés en zones partielles de même fonction, n'est pas subdivisée et est reliée à la sortie d'au moins un inverseur CMOS (14) couplé par réaction à son entrée, les transistors de cet inverseur possédant les mêmes dimensions spatiales que celles des transistors subdivisés en zone partielles, ou des dimensions spatiales proportionnelles à celles de ces transistors.

4. Capteur de champ magnétique selon l'une des revendications 1 à 3, caractérisé en ce que la première zone partielle de l'un des deux transistors complémentaires (3, 4) est reliée à la troisième zone non subdivisée du même transistor subdivisé en zones partielles, que la seconde zone partielle de ce transistor forme une sortie unipolaire du capteur de champ magnétique et qu'un pôle de l'entrée ou de la sortie de la tension d'alimentation est alimenté par une source à courant continu (27).

5. Capteur de champ magnétique selon l'une des revendications 1 à 3, caractérisé en ce que, à l'aide de deux commutateurs-inverseurs (28, 30 ; 29, 31) fonctionnant en push-pull, en alternance d'une part la première zone partielle de l'un des deux transistors complémentaires est reliée au premier pôle d'une sortie (23) du signal de capteur de champ magnétique et la seconde zone partielle de ce transistor est reliée à la troisième zone non subdivisée de ce transistor, et d'autre part la première zone partielle du même transistor est reliée à la troisième zone de ce transistor et sa seconde zone partielle est reliée au second pôle d'une sortie (24) du signal, et qu'un pôle de l'entrée ou de la sortie de la tension d'alimentation est alimenté par une source à courant continu.

6. Capteur de champ magnétique selon la revendication 1 ou 2, caractérisé en ce que la troisième zone des deux transistors complémentaires est également constituée par deux zones partielles.

7. Capteur de champ magnétique selon la revendication 6, caractérisé en ce que les deux zones partielles constituant la troisième zone du premier transistor (3) sont court-circuitées et sont reliées par l'intermédiaire de résistances respectives (R1, R2) aux deux zones partielles de la troisième zone du second transistor (4), et que la première zone partielle de la troisième zone du second transistor (4) est raccordée par l'intermédiaire d'une troisième résistance (R3) à la première zone partielle de la première zone du premier transistor (3), et que la seconde zone partielle de la troisième zone du second transistor (4) est raccordée par l'intermédiaire d'une quatrième résistance (R4) à la sortie d'un étage suiveur de tension (32b), dont l'entrée est reliée pour sa part à la seconde zone partielle de la première zone du premier transistor (3).

8. Capteur de champ magnétique selon la revendication 1 ou 2, caractérisé en ce que chaque troisième zone des transistors (3 ; 4), dont la première zone est subdivisée en zones partielles séparées, est une zone de « grille » non subdivisée d'un transistor MOS, qui s'étend au-dessus des canaux subdivisés de ces transistors MOS et est constituée en un matériau possédant une résistance finie, mais très élevée et possède une borne respective à chacune de ses deux extrémités.

9. Capteur de champ magnétique selon la revendication 8, caractérisé en ce que la première zone partielle de « drain » (35a) du premier transistor (3) est reliée d'une part directement à la seconde zone partielle de « drain » (38b) du second transistor (4) et au second pôle (6) de la sortie bipolaire (5 ; 6) du capteur de champ magnétique, et d'autre part par l'intermédiaire d'un étage suiveur de tension (32b) à la seconde borne de « grille » du premier transistor (3) et à la première borne de « grille » du second transistor (4), et que la première borne de « grille » et la seconde zone partielle de « drain » (35b) du premier transistor (3) sont reliées à la première zone partielle de « drain » (38a) et à la seconde borne de « grille » du second transistor (4) ainsi qu'au premier pôle (5) de la sortie bipolaire (5 ; 6) du capteur de champ magnétique.

10. Capteur de champ magnétique selon la revendication 1, caractérisé en ce que chaque première zone des transistors, constituée par deux zones partielles, forment la zone de collecteur et que chaque seconde zone des transistors, constituant un pôle de l'entrée ou de la sortie de la tension d'alimentation, constitue la zone d'émetteur des deux transistors bipolaires complémentaires.

11. Capteur de champ magnétique selon la revendication 5, caractérisé en ce que les commutateurs-inverseurs (28, 30 ; 29, 31) sont réalisés à l'aide de transistors à effet de champ.

12. Capteur de champ magnétique selon la revendication 5, caractérisé en ce que les commutateurs-inverseurs (28, 30 ; 29, 31) sont réalisés au moyen de « transmission gates ».

13. Capteur de champ magnétique selon la revendication 5, caractérisé en ce que les contacts fermés des deux commutateurs-inverseurs (28, 30 ; 29, 31) sont remplacés respectivement par une liaison de court-circuit.

14. Capteur de champ magnétique selon l'une des revendications 1 à 13, caractérisé en ce qu'en parallèle avec la sortie bipolaire (5 ; 6 ou 23 ;24) du capteur de champ magnétique se trouve branché un régulateur de tension (15), qui règle la tension de zéro du capteur de champ magnétique à zéro et qui est constitué par un intégrateur (17a ; 17b), un réseau de stabilisation (19a ; 19b) et une source de courant (16a ; 16b), commandée par la tension, pour chaque conducteur de sortie, ainsi que par un seul amplificateur différentiel (18).

15. Capteur de champ magnétique selon la revendication 14, caractérisé en ce que les intégrateurs (17a ; 17b) sont des circuits RC.

16. Capteur de champ magnétique selon l'une des revendications 1 à 4, caractérisé en ce qu'il constitue l'élément de mesure d'un compteur électrique.

17. Capteur de champ magnétique selon la revendication 16, caractérisé en ce qu'il est disposé dans l'entrefer, parallèle à l'axe, d'un noyau magnétique en forme de cylindre annulaire (41), de telle sorte que sa surface est parallèle aux surfaces latérales du noyau magnétique limitant l'entrefer (42), auquel cas les dimensions de ces surfaces latérales du noyau magnétique sont nettement supérieures aux dimensions du capteur de champ magnétique et le courant électrique à mesurer parcourt un conducteur électrique (40) qui est disposé suivant l'axe longitudinal du noyau magnétique.

18. Capteur de champ magnétique selon la revendication 17, caractérisé en ce que les surfaces latérales du noyau magnétique, qui délimitent l'entrefer (42), sont parallèles entre elles et à la surface du capteur de champ magnétique, sur la face intérieure radiale de l'anneau, et qu'au contraire, sur la face extérieure radiale de l'anneau, elles s'écartent l'une de l'autre sous un angle double (deux fois 43) qui délimite un segment circulaire dans la section transversale du noyau magnétique.

# Fig. 1

# Fig. 2

# Fig. 3

# Fig. 4

# Fig. 5

# Fig. 6

# Fig. 7

# Fig. 8

# Fig. 9

# Fig. 10

## Fig. 11a

42
40
41

## Fig. 11b

42
40
1a; 1b; 1c; 1d
41

## Fig. 11c

41
43
42